(19) **Europäisches Patentamt / European Patent Office / Office européen des brevets**

(11) **EP 3 258 484 A1**

(12) **EUROPEAN PATENT APPLICATION**
published in accordance with Art. 153(4) EPC

(43) Date of publication:
**20.12.2017 Bulletin 2017/51**

(21) Application number: **16749152.1**

(22) Date of filing: **04.02.2016**

(51) Int Cl.:
*H01L 21/304* [(2006.01)]     *B24B 37/00* [(2012.01)]
*C09G 1/02* [(2006.01)]     *C09K 3/14* [(2006.01)]

(86) International application number:
**PCT/JP2016/053419**

(87) International publication number:
**WO 2016/129508 (18.08.2016 Gazette 2016/33)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **10.02.2015 JP 2015024377**

(71) Applicant: **Fujimi Incorporated
Kiyosu-shi, Aichi 452-8502 (JP)**

(72) Inventor: **IZAWA, Yoshihiro
Kiyosu-shi
Aichi 452-8502 (JP)**

(74) Representative: **Grünecker Patent- und
Rechtsanwälte
PartG mbB
Leopoldstraße 4
80802 München (DE)**

(54) **POLISHING COMPOSITION**

(57)     The present invention provides a polishing composition capable of polishing a simple substance of silicon at a higher polishing speed.

The present invention is a polishing composition which is used for polishing a polishing object containing a simple substance of silicon and a silicon-containing compound other than the simple substance of silicon, the polishing composition including: abrasive grains; and a dispersing medium, wherein the number of silanol groups per unit surface area of the abrasive grains is more than $0/nm^2$ but $2.0/nm^2$ or less.

EP 3 258 484 A1

**Description**

**TECHNICAL FIELD**

The present invention relates to a polishing composition.

**BACKGROUND ART**

In recent years, new fine processing techniques have been developed along with high integration and high performance of large scale integration (LSI). A chemical mechanical polishing (CMP) method is one of the techniques, and is a technique frequently used for planarization of an interlayer insulating film, metal plug formation, and buried wiring (damascene wiring) formation in an LSI production process, in particular, in a multilayer wiring forming process.
The CMP has been applied to each process in manufacturing of a semiconductor, and as an aspect thereof, for example, application to a gate forming process in production of a transistor is mentioned. At the time of producing a transistor, a Si-containing material such as silicon, polycrystalline silicon (polysilicon), or silicon nitride is polished in some cases, and thus there is a demand for controlling the polishing rate of each Si-containing material depending on the structure of the transistor.
For example, techniques of polishing polysilicon by a polishing agent containing abrasive grains, a surfactant, and the like are disclosed in JP 2013-41992 A, WO 2008/105223 A (corresponding to US 2010/0001229 A1), and JP 2006-344786 A.

**SUMMARY OF INVENTION**

However, polishing compositions described in the above-described patent literatures show insufficient improvement in the polishing speed of a simple substance of silicon such as polysilicon, and thus there is a demand for further improvement.
In this regard, an object of the present invention is to provide a polishing composition capable of polishing a simple substance of silicon at a higher polishing speed.
The present inventors have been conducted intensive studies in order to solve the above-described problem. As a result, it is found that the above-described problem is solved by a polishing composition in which the number of silanol groups per unit surface area of abrasive grains contained in the polishing composition is in a specific range. Thus, the present invention has been completed on the basis of the above finding.
That is, the present invention is a polishing composition which is used for polishing a polishing object containing a simple substance of silicon and a silicon-containing compound other than the simple substance of silicon, the polishing composition including: abrasive grains; and a dispersing medium, wherein the number of silanol groups per unit surface area of the abrasive grains is more than $0/nm^2$ but $2.0/nm^2$ or less.

**DESCRIPTION OF EMBODIMENTS**

The present invention is a polishing composition which is used for polishing a polishing object containing a simple substance of silicon and a silicon-containing compound other than the simple substance of silicon, the polishing composition containing: abrasive grains; and a dispersing medium, in which the number of silanol groups per unit surface area of the abrasive grains is more than $0/nm^2$ but $2.0/nm^2$ or less. The polishing composition of the present invention having such a configuration can polish the simple substance of silicon at a higher polishing speed.
The detailed reason for improving the polishing speed of the simple substance of silicon in the case of using the polishing composition of the present invention is not clear, but the reason for this is considered as follows. Incidentally, the present invention is not limited to the following description.
That is, when the number of silanol groups per unit surface area of the abrasive grains (hereinafter, also simply referred to as the number of silanol groups) is set to more than $0/nm^2$ but $2.0/nm^2$ or less, the hydrophobicity of the surfaces of the abrasive grains becomes higher and the interaction with the simple substance of silicon having a hydrophobic surface similarly becomes stronger. As a result, it is considered that the polishing speed of the simple substance of silicon is improved.
Conventionally, in the case of decreasing the number of silanol groups of the surfaces of the abrasive grains, binding between the abrasive grains and/or between the surfaces of the abrasive grains becomes stronger. As a result, the hardness of the abrasive grains is increased. For this reason, regardless of the type of the material of the polishing object, improvement in the polishing speed is recognized.
However, in the present invention, there is found the functional mechanism, which has not been hitherto known, that by setting the number of silanol groups per unit surface area of the abrasive grains to a specific range, the hydrophobicity of the surfaces of the abrasive grains becomes higher and the interaction with the simple substance of silicon having a hydrophobic surface similarly becomes stronger so that the polishing speed of the simple substance of silicon is improved, and thus it is found that the above-described problem is solved. In addition, by using the polishing composition of the present invention, it is possible to obtain an effect that the polishing speed of the silicon-containing compound other than the simple substance of silicon can be maintained or suppressed while the polishing speed of the simple substance of silicon is improved, that is, an effect that a ratio (selectivity) of the polishing speed of the simple substance of silicon to the polishing speed of the silicon-containing compound other than the simple substance of silicon is improved.

Hereinafter, the present invention will be described in detail.

[Polishing Object]

A polishing object according to the present invention contains a simple substance of silicon and a silicon-containing compound other than the simple substance of silicon. Examples of the simple substance of silicon include polysilicon (Poly Si, polycrystalline silicon), single crystal silicon, and amorphous silicon.

Examples of the silicon-containing compound other than the simple substance of silicon include silicon oxide ($SiO_2$), silicon nitride (SiN), and tetraethyl orthosilicate (TEOS) . These silicon-containing compounds can be used either singly or in mixture of two or more kinds thereof.

Next, the configuration of the polishing composition of the present invention will be described in detail.

[Abrasive Grains]

Abrasive grains contained in the polishing composition have an action of mechanically polishing a polishing object and improve the polishing speed of the polishing object by the polishing composition.

The abrasive grains to be used in the present invention are not particularly limited as long as they have a silanol group. Specific examples thereof include particles composed of a metal oxide such as silica, alumina, zirconia, or titania. The abrasive grains may be used either singly or in mixture of two or more kinds thereof. Moreover, the abrasive grains used may be a commercially available product or a synthetic product.

Among these abrasive grains, silica is preferable, fumed silica and colloidal silica are more preferable, and colloidal silica is particularly preferable. As a method for producing colloidal silica, a silicate soda method and a sol-gel method are mentioned, and any colloidal silica produced by any of these production methods is suitably used as the abrasive grains of the present invention. However, from the viewpoint of reducing metal impurities, colloidal silica produced by a sol-gel method which can produce colloidal silica with high purity is preferable.

Further, the abrasive grains may be surface-modified as long as the number of silanol groups per unit surface area satisfies the above range. Among them, colloidal silica having an organic acid immobilized is particularly preferable. The immobilization of an organic acid on the surface of colloidal silica contained in the polishing composition is performed, for example, by chemically bonding the functional group of the organic acid on the surface of colloidal silica. The immobilization of an organic acid to colloidal silica cannot be accomplished by only allowing colloidal silica to simply coexist with an organic acid. It is possible to perform the immobilization, for example, by the method described in "Sulfonic acid-functionalized silica through quantitative oxidation of thiol groups," Chem. Commun. 246-247 (2003) when sulfonic acid of a kind of organic acids is immobilized on colloidal silica. Specifically, it is possible to obtain colloidal silica having sulfonic acid immobilized on the surface by coupling a silane coupling agent having a thiol group such as 3-mercaptopropyltrimethoxysilane to colloidal silica and then oxidizing the thiol group with hydrogen peroxide. Alternatively, it is possible to perform the immobilization, for example, by the method described in "Novel Silane Coupling Agents Containing a Photolabile 2-Nitrobenzyl Ester for Introduction of a Carboxy Group on the Surface of Silica Gel," Chemistry Letters, 3, 228-229 (2000) when carboxylic acid is immobilized on colloidal silica. Specifically, it is possible to obtain colloidal silica having carboxylic acid immobilized on the surface by coupling a silane coupling agent containing a photoreactive 2-nitrobenzyl ester to colloidal silica and then irradiating with light.

The number of silanol groups per unit surface area of the abrasive grains contained in the polishing composition of the present invention is in a range of more than $0/nm^2$ but $2.0/nm^2$ or less. When there is no silanol group on the surfaces of the abrasive grains, that is, the number of silanol groups per unit surface area is $0/nm^2$, the abrasive grains are aggregated, and thus the polishing speed of the simple substance of silicon is decreased. On the other hand, when the number of silanol groups per unit surface area is more than $2.0/nm^2$, the hydrophobic interaction with the polishing object is decreased by an increase in the number of hydrophilic groups on the surfaces of the abrasive grains, and thus the polishing speed of the simple substance of silicon is decreased. The number of silanol groups per unit surface area of the abrasive grains is preferably $0.5/nm^2$ or more but $2.0/nm^2$ or less.

The number of silanol groups per unit surface area of the abrasive grains can be calculated by the Sears method using neutralization titration described in Analytical Chemistry, vol. 28, No. 12, 1956, 1982 to 1983 by G. W. Sears. The calculation formula for the number of silanol groups is calculated by the following equation.

[Mathematical Formula 1]

$$\rho = \frac{(c \times a \times N_A)}{(C \times S)}$$

$\rho$: Number of silanol groups [count/nm$^2$]
c : Concentration of sodium hydrate solution used in titration [mol/L]
a: Amount of sodium hydrate solution having pH of 4 to 9 added dropwise [ml]
$N_A$: Avogadro's number ($6.022 \times 10^{23}$ [count/mol])
C: Mass of silica [g]
S: BET specific surface area [nm$^2$/g]

The number of silanol groups per unit surface area of the abrasive grains can be controlled by selection of the method for producing abrasive grains, or the like.

The lower limit of the average secondary particle size of the abrasive grains is preferably 5 nm or more, more preferably 7 nm or more, and further preferably 10 nm or more. In addition, the upper limit of the average secondary particle size of the abrasive grains is preferably 500 nm or less, more preferably 300 nm or less, and further preferably 200 nm or less. With such a range, the polishing speed of the simple substance of silicon by the polishing composition is improved.

Further, the occurrence of dishing on the surface of the polishing object after being polished using the polishing composition can be further suppressed. Incidentally, the average secondary particle size of the abrasive grains is calculated, for example, by a dynamic light scattering method.

The lower limit of the content of the abrasive grains in the polishing composition is preferably 0.002% by mass or more, more preferably 0.02% by mass or more, and further preferably 0.1% by mass or more. In addition, the upper limit of the content of the abrasive grains in the polishing composition is preferably 10% by mass or less, more preferably 8% by mass or less, further preferably 5% by mass or less. With such a range, a high polishing speed is achieved while costs are suppressed, and processing can be performed efficiently.

[Water]

The polishing composition of the present invention contains a dispersing medium for dispersing each component. Water is preferable as a dispersing medium. Water containing impurities as little as possible is preferable from the viewpoint of suppressing the inhibition of the impurities on the action of other components, and specifically, pure water, ultrapure water, or distilled water from which the impurity ions are removed by an ion exchange resin and then the foreign matters are removed through filtration is preferable.

[pH of Polishing Composition]

The pH of the polishing composition of the present invention is not particularly limited, and the effect of improving the polishing speed of the simple substance of silicon is exerted in a broad pH range. However, from the viewpoint of the dispersion stability of the abrasive grains, the lower limit of pH is preferably pH 1.0 or more and more preferably pH 2.0 or more. In addition, the upper limit of pH is preferably pH 12 or less and more preferably pH 10.5 or less.

The pH can be adjusted by adding an appropriate amount of pH adjusting agent. A pH adjusting agent used, if necessary, for adjusting the pH of the polishing composition to a desired value may be either an acid or an alkali, and either an inorganic compound or an organic compound. Specific examples of the acid include an inorganic acid such as sulfuric acid, nitric acid, boric acid, carbonic acid, hypophosphorous acid, phosphorous acid, or phosphoric acid; and an organic acid such as a carboxylic acid including formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, an organic sulfuric acid including methanesulfonic acid, ethanesulfonic acid, and isethionic acid, or an organophosphorus acid including phytic acid and hydroxyethylidene diphosphonic acid. Specific examples of the alkali include a hydroxide of an alkali metal such as potassium hydroxide, an amine such as ammonia, ethylene diamine, or piperazine, and a quaternary ammonium salt such as tetramethyl ammonium or tetraethyl ammonium. These pH adjusting agents can be used either singly or in mixture of two or more kinds thereof.

EP 3 258 484 A1

[Other Components]

The polishing composition of the present invention may further contain, if necessary, other components such as an oxidant, a metal anticorrosive, an antiseptic agent, an antifungal agent, a water-soluble polymer, and an organic solvent for dissolving a sparingly soluble organic substance. Hereinafter, an oxidant, a metal anticorrosive, an antiseptic agent, and an antifungal agent that are preferred other components will be described.

[Oxidant]

The oxidant that may be added to the polishing composition has an action of oxidizing the surface of the polishing object and improves the polishing speed of the polishing object by the polishing composition.

Examples of the oxidant that is usable include hydrogen peroxide, sodium peroxide, barium peroxide, ozone water, a silver (II) salt, iron (III) salt, permanganic acid, chromic acid, dichromic acid, peroxodisulfuric acid, peroxophosphoric acid, peroxosulfuric acid, peroxoboric acid, performic acid, peracetic acid, perbenzoic acid, perphthalic acid, hypochlorous acid, hypobromous acid, hypoiodous acid, chloric acid, chlorous acid, perchloric acid, bromic acid, iodic acid, periodic acid, persulfuric acid, dichloroisocyanuric acid, and salts thereof. These oxidants may be used either singly or in mixture of two or more kinds thereof.

The content of the oxidant in the polishing composition is preferably 0.1 g/L or more, more preferably 1 g/L or more, and further preferably 3 g/L or more. As the content of the oxidant increases, the polishing speed of the polishing object by the polishing composition is further improved.

The content of the oxidant in the polishing composition is also preferably 200 g/L or less, more preferably 100 g/L or less, and further preferably 40 g/L or less. As the content of the oxidant decreases, the costs of materials of the polishing composition can be suppressed, and a load of treatment of the polishing composition after using the polishing composition for polishing, that is, a load of a waste water treatment can be reduced. In addition, it is possible to reduce a possibility that excessive oxidation on the surface of the polishing object caused by the oxidant occurs.

[Metal Anticorrosive]

With the addition of the metal anticorrosive into the polishing composition, the occurrence of a depression at the side of the wiring due to the polishing using the polishing composition can be further suppressed. Further, the occurrence of dishing on the surface of the polishing object after being polished using the polishing composition can be further suppressed.

The usable metal anticorrosive is not particularly limited; however, a heterocyclic compound or a surfactant is preferable. The number of members in the heterocyclic ring in the heterocyclic compound is not particularly limited. In addition, the heterocyclic compound may be a monocyclic compound or may be a polycyclic compound having a condensed ring. The metal anticorrosive may be used either singly or in mixture of two or more kinds thereof. Further, the metal anticorrosive used may be a commercially available product or a synthetic product.

Specific examples of the heterocyclic compound usable as the metal anticorrosive include a nitrogen-containing heterocyclic compound such as a pyrrole compound, a pyrazole compound, an imidazole compound, a triazole compound, a tetrazole compound, a pyridine compound, a pyrazine compound, a pyridazine compound, a pyrindine compound, an indolizine compound, an indole compound, an isoindole compound, an indazole compound, a purine compound, a quinolizine compound, a quinoline compound, an isoquinoline compound, a naphthyridine compound, a phthalazine compound, a quinoxaline compound, a quinazoline compound, a cinnoline compound, a pteridine compound, a thiazole compound, an isothiazole compound, an oxazole compound, an isoxazole compound, or a furazan compound.

[Antiseptic Agent and Antifungal Agent]

Examples of the antiseptic agent and the antifungal agent to be used in the present invention include an isothiazolin-based antiseptic agent such as 2-methyl-4-isothiazolin-3-one or 5-chloro-2-methyl-4-isothiazolin-3-one, paraoxybenzoate ester, and phenoxyethanol. These antiseptic agents and antifungal agents may be used either singly or in mixture of two or more kinds thereof.

[Method for Producing Polishing Composition]

A method for producing the polishing composition of the present invention is not particularly limited. The polishing composition can be obtained, for example, by stirring and mixing abrasive grains, and if necessary, another component in water.

The temperature at the time of mixing each component is not particularly limited, but is preferably 10 to 40°C.

The components may be heated in order to increase a rate of dissolution. Further, the mixing time is not particularly limited, either.

[Polishing Method and Method for Manufacturing Substrate]

As described above, the polishing composition of the present invention is particularly suitably used for polishing a polishing object containing a simple substance of silicon and a silicon-containing compound other than the simple substance of silicon. Therefore, the present invention provides a method for polishing a polishing object containing a simple substance of silicon and a silicon-containing compound other than the simple substance of silicon by using the polishing composition of the present invention. In addition, the present invention provides a method for manufacturing a substrate, the method including a process of polishing a polishing object containing a simple substance of silicon and a silicon-containing compound other than the simple substance of silicon by the above-described polishing method.

As a polishing apparatus, it is possible to use a general polishing apparatus to which a holder for holding a substrate or the like having a polishing object and a motor with a changeable rotating speed and the like are attached, having a polishing table to which a polishing pad (polishing cloth) can be attached.

As the polishing pad, a general nonwoven fabric, polyurethane, a porous fluororesin, or the like can be used without any particular limitation. The polishing pad is preferably grooved such that a polishing liquid can be stored therein.

Polishing conditions are not particularly limited, either. For example, the rotational speed of the polishing table is preferably 10 to 500 rpm, and the pressure (the polishing pressure) applied to a substrate having a polishing object is preferably 0.5 to 10 psi. A method for supplying a polishing composition to a polishing pad is not particularly limited, either. For example, a method in which a polishing composition is supplied continuously by using a pump or the like is employed. The supply amount is not limited, but a surface of the polishing pad is preferably covered all the time with the polishing composition of the present invention.

After polishing is completed, the substrate is washed with running water, the substrate is dried by flicking off water droplets adhering onto the surface of the substrate by using a spin dryer or the like, and as a result, a substrate including a layer having a metal or a silicon-containing material is obtained.

**Examples**

The present invention will be described in more detail by means of the following Examples and Comparative Examples. However, the technical scope of the present invention is not limited to only the following Examples.

Incidentally, the number of silanol groups per unit surface area of the abrasive grains (unit: count/$nm^2$) was calculated by the following method after each parameter was measured or calculated by the following measurement method or the following calculation method. Further, the average secondary particle size of the abrasive grains was measured by a dynamic light scattering particle size measuring apparatus.

<Method for Calculating Number of Silanol Groups>

The number of silanol groups per unit surface area of the abrasive grains can be calculated by the Sears method using neutralization titration described in Analytical Chemistry, vol. 28, No. 12, 1956, 1982 to 1983 by G. W. Sears. The calculation formula for the number of silanol groups is calculated by the following equation.

[Mathematical Formula 2]

$$\rho = \frac{(c \times a \times N_A)}{(C \times S)}$$

$\rho$: Number of silanol groups [count/$nm^2$]
c : Concentration of sodium hydrate solution used in titration [mol/L]
a: Amount of sodium hydrate solution having pH of 4 to 9 added dropwise [ml]
$N_A$: Avogadro's number ($6.022 \times 10^{23}$ [count/mol])
C: Mass of silica [g]
S: BET specific surface area [$nm^2$/g]

[Polishing at pH 4]

(Example 1-1)

A polishing composition was prepared by mixing colloidal silica having the number of silanol groups of $1.5/nm^2$ (average secondary particle size: 67 nm, synthesized by a sol-gel method) as abrasive grains with water to have a concentration of 0.1% by mass (mixing temperature: 25°C, mixing time: 10 min), and further adding nitric acid as a pH adjusting agent to adjust pH. The pH of the polishing composition was confirmed with a pH meter to be 4.

(Example 1-2)

A polishing composition was prepared in the same manner as in Example 1-1, except that the concentration of the abrasive grains in the polishing composition was changed to 4% by mass.

(Example 1-3)

A polishing composition was prepared by mixing colloidal silica having the number of silanol groups of $1.6/nm^2$ (one synthesized by a silicate soda method) as abrasive grains with water to have a concentration of 4% by mass (mixing temperature: 25°C, mixing time: 10 min), and further adding nitric acid as a pH adjusting agent to adjust pH. The pH of the polishing composition was confirmed with a pH meter to be 4.

(Example 1-4)

A polishing composition was prepared by mixing fumed silica having the number of silanol groups of $1.9/nm^2$ as abrasive grains with water to have a concentration of 1% by mass (mixing temperature: 25°C, mixing time: 10 min), and further adding nitric acid as a pH adjusting agent to adjust pH. The pH of the polishing composition was confirmed with a pH meter to be 4.

(Comparative Example 1-1)

A polishing composition was prepared in the same manner as in Example 1-1, except that colloidal silica having the number of silanol groups of $5.7/nm^2$ (trade name: SS-3P, manufactured by FUSO CHEMICAL CO., LTD., average secondary particle size: 70 nm, one synthesized by a sol-gel method) was used as abrasive grains.

(Comparative Example 1-2)

A polishing composition was prepared in the same manner as in Example 1-2, except that colloidal silica having the number of silanol groups of $5.7/nm^2$ (trade name: SS-3P, manufactured by FUSO CHEMICAL CO., LTD., average secondary particle size: 70 nm, one synthesized by a sol-gel method) was used as abrasive grains.

(Comparative Example 1-3)

A polishing composition was prepared in the same manner as in Example 1-1, except that $\alpha$-alumina having no silanol group was used as abrasive grains.

(Comparative Example 1-4)

A polishing composition was prepared in the same manner as in Example 1-1, except that $\gamma$-alumina having no silanol group was used as abrasive grains.

(Evaluation)

<True Density of Abrasive Grains>

The true density of the abrasive grains was calculated by a pycnometer method represented by the following equation.

[Mathematical Formula 3]

$$Sg = \frac{(Wb-Wa) \times Ld}{(Wd-Wc+Wb-Wa)}$$

Sg: True density of abrasive grains
Wa: Mass of pycnometer
Wb: Mass of sample and pycnometer
Wc: Mass of sample, ethanol, and pycnometer
Wd: Mass of ethanol and pycnometer
Ld: Specific gravity of ethanol

<Polishing Speed>

The polishing speed was calculated by the following equation.

[Mathematical Formula 4]

$$\text{Polishing rate [Å/min]} = \frac{\text{Film thickness before polishing [Å]} - \text{Film thickness after polishing [Å]}}{\text{Polishing time [min]}}$$

The film thicknesses of Poly Si, SiN, and TEOS were obtained by an optical interferometric film thickness measurement apparatus and evaluation was carried out by dividing a difference between the film thicknesses by polishing time.
The evaluation results of the polishing compositions of Examples 1-1 to 1-4 and Comparative Examples 1-1 to 1-4 are presented in the following Table 1. Incidentally, in the column entitled selectivity in Tables 1 to 3, a value obtained by dividing the polishing speed of Poly Si by the polishing speed of TEOS is shown in the column entitled "Poly Si/TEOS" and a value obtained by dividing the polishing speed of Poly Si by the polishing speed of SiN is shown in the column entitled "Poly Si/SiN."

[Table 1]

| | Abrasive grains | | | | | Polishing composition | | Polishing speed (A/min) | | | Selectivity | |
|---|---|---|---|---|---|---|---|---|---|---|---|---|
| | Type | Mohs hardness | Number of silanol groups (count/nm²) | True density (g/cm³) | Producing method | Concentration of abrasive grains (% by mass) | pH | Poly Si | TEOS | SiN | Poly Si /TEOS | Poly Si /SiN |
| Example 1-1 | Colloidal silica | 7 | 1.5 | 2.18 | Sol-gel method | 0.1 | 4 | 201 | 3 | 85 | 77.3 | 2.4 |
| Example 1-2 | Colloidal silica | 7 | 1.5 | 2.18 | Sol-gel method | 4 | 4 | 828 | 30 | 256 | 27.6 | 3.2 |
| Example 1-3 | Colloidal silica | 7 | 1.6 | 2.19 | Silicate soda method | 4 | 4 | 73 | 18 | 75 | 4.0 | 1.0 |
| Example 1-4 | Fumed silica | 7 | 1.9 | 2.66 | - | 1 | 4 | 120 | 15 | 151 | 8.0 | 0.8 |
| Comparative Example 1-1 | Colloidal silica | 7 | 5.7 | 1.82 | Sol-gel method | 0.1 | 4 | 23 | 2 | 66 | 10.6 | 0.4 |
| Comparative Example 1-2 | Colloidal silica | 7 | 5.7 | 1.82 | Sol-gel method | 4 | 4 | 55 | 27 | 206 | 2.1 | 0.3 |
| Comparative Example 1-3 | α-alumina | 9 | 0 | 3.95 | - | 0.1 | 4 | 94 | 25 | 81 | 3.8 | 1.2 |
| Comparative Example 1-4 | γ-alumina | 7 | 0 | 3.95 | - | 0.1 | 4 | 101 | 31 | 42 | 3.3 | 2.4 |

As presented in the above Table 1, it was found that the polishing compositions of Examples 1-1 to 1-4 further improve the polishing speed of polysilicon (Poly Si) as compared to the polishing compositions of Comparative Examples 1-1 to 1-4. In addition, the ratio (selectivity) of the polishing speed of polysilicon (Poly Si) to the polishing speed of TEOS in Example 1-1 and Example 1-2 was improved as compared to Comparative Examples 1-1 to 1-4.

[Polishing at pH 7]

(Example 2-1)

A polishing composition was prepared in the same manner as in Example 1-2, except that nitric acid and potassium hydroxide were used as a pH adjusting agent and the pH of the polishing composition was adjusted to 7.

(Comparative Example 2-1)

A polishing composition was prepared in the same manner as in Comparative Example 1-2, except that nitric acid and potassium hydroxide were used as a pH adjusting agent and the pH of the polishing composition was adjusted to 7.
The evaluation results of the polishing compositions of Example 2-1 and Comparative Example 2-1 are presented in the following Table 2.

[Table 2]

| | Abrasive grains | | | | | Polishing composition | | Polishing speed (A/min) | | | Selectivity | |
|---|---|---|---|---|---|---|---|---|---|---|---|---|
| | Type | Mohs hardness | Number of silanol groups (count/nm$^2$) | True density (g/cm$^3$) | Producing method | Concentration of abrasive grains (% by mass) | pH | Poly Si | TEOS | SiN | Poly Si /TEOS | Poly Si /SiN |
| Example 2-1 | Colloidal silica | 7 | 1.5 | 2.18 | Sol-gel method | 4 | 7 | 834 | 9 | 16 | 89.2 | 53.4 |
| Comparative Example 2-1 | Colloidal silica | 7 | 5.7 | 1.82 | Sol-gel method | 4 | 7 | 138 | 8 | 20 | 17.2 | 6.9 |

As presented in the above Table 2, it was found that the polishing composition of Example 2-1 further improves the polishing speed of polysilicon (Poly Si) as compared to the polishing composition of Comparative Example 2-1. In addition, the ratio (selectivity) of the polishing speed of polysilicon (Poly Si) to the polishing speed of TEOS and the ratio (selectivity) of the polishing speed of polysilicon (Poly Si) to the polishing speed of SiN in Example 2-1 were improved as compared to Comparative Example 2-1.

[Polishing at pH 10]

(Example 3-1)

A polishing composition was prepared in the same manner as in Example 1-2, except that potassium hydroxide was used as a pH adjusting agent and the pH of the polishing composition was adjusted to 10.

(Comparative Example 3-1)

A polishing composition was prepared in the same manner as in Comparative Example 1-2, except that potassium hydroxide was used as a pH adjusting agent and the pH of the polishing composition was adjusted to 10.
The evaluation results of the polishing compositions of Example 3-1 and Comparative Example 3-1 are presented in the following Table 3.

[Table 3]

| | Abrasive grains | | | | | Polishing composition | | Polishing speed (A/min) | | | Selectivity | |
|---|---|---|---|---|---|---|---|---|---|---|---|---|
| | Type | Mohs hardness | Number of silanol groups (count/nm$^2$) | True density (g/cm$^3$) | Producing method | Concentration of abrasive grains (% by mass) | pH | Poly Si | TEOS | SiN | Poly Si /TEOS | Poly Si /SiN |
| Example 3-1 | Colloidal silica | 7 | 1.5 | 2.18 | Sol-gel method | 4 | 10 | 1727 | 26 | 10 | 66.4 | 166.3 |
| Comparative Example 3-1 | Colloidal silica | 7 | 5.7 | 1.82 | Sol-gel method | 4 | 10 | 1418 | 25 | 9 | 56.7 | 157.5 |

As presented in the above Table 3, the ratio (selectivity) of the polishing speed of polysilicon (Poly Si) to the polishing speed of TEOS and the ratio (selectivity) of the polishing speed of polysilicon (Poly Si) to the polishing speed of SiN in the polishing composition of Example 3-1 were improved as compared to the polishing composition of Comparative Example 3-1.

Incidentally, the present application is based on Japanese Patent Application No. 2015-024377, filed on February 10, 2015, the entire contents of which are incorporated herein by reference.

**Claims**

1. A polishing composition which is used for polishing a polishing object containing a simple substance of silicon and a silicon-containing compound other than the simple substance of silicon, the polishing composition comprising:

   abrasive grains; and
   a dispersing medium, wherein
   the number of silanol groups per unit surface area of the abrasive grains is more than $0/nm^2$ but $2.0/nm^2$ or less.

2. The polishing composition according to claim 1, wherein the abrasive grains are colloidal silica.

3. The polishing composition according to claim 2, wherein the colloidal silica is the one produced by a sol-gel method.

4. A method for polishing a polishing object containing a simple substance of silicon and a silicon-containing compound other than the simple substance of silicon by the polishing composition according to any one of claims 1 to 3.

5. A method for manufacturing a substrate, the method comprising a process of polishing a polishing object containing a simple substance of silicon and a silicon-containing compound other than the simple substance of silicon by the polishing method according to claim 4.

**EP 3 258 484 A1**

<div align="center">

**INTERNATIONAL SEARCH REPORT**

</div>

| International application No. |
| --- |
| PCT/JP2016/053419 |

**A.    CLASSIFICATION OF SUBJECT MATTER**
*H01L21/304*(2006.01)i, *B24B37/00*(2012.01)i, *C09G1/02*(2006.01)i, *C09K3/14*(2006.01)i

According to International Patent Classification (IPC) or to both national classification and IPC

**B.    FIELDS SEARCHED**

Minimum documentation searched (classification system followed by classification symbols)
H01L21/304, B24B37/00, C09G1/02, C09K3/14

Documentation searched other than minimum documentation to the extent that such documents are included in the fields searched
Jitsuyo Shinan Koho          1922–1996    Jitsuyo Shinan Toroku Koho    1996–2016
Kokai Jitsuyo Shinan Koho    1971–2016    Toroku Jitsuyo Shinan Koho    1994–2016

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2006-231436 A  (Tokyo Seimitsu Co., Ltd.),<br>07 September 2006 (07.09.2006),<br>paragraphs [0021] to [0023], [0031], [0037]<br>(Family: none) | 1-2,4-5<br>3 |
| Y | JP 2010-067914 A  (Fujifilm Corp.),<br>25 March 2010 (25.03.2010),<br>paragraph [0043]<br>(Family: none) | 3 |
| Y | JP 2012-212081 A  (Hoya Corp.),<br>01 November 2012 (01.11.2012),<br>paragraph [0058]<br>(Family: none) | 3 |

[×]  Further documents are listed in the continuation of Box C.          [ ]  See patent family annex.

| | |
| --- | --- |
| *     Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| 16 May 2016 (16.05.16) | 24 May 2016 (24.05.16) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
| --- | --- |

Form PCT/ISA/210 (second sheet) (January 2015)

**INTERNATIONAL SEARCH REPORT**

International application No.

PCT/JP2016/053419

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2009-289885 A  (Fujifilm Corp.),<br>10 December 2009 (10.12.2009),<br>paragraphs [0100] to [0105]<br>(Family: none) | 1-5 |
| A | JP 2010-034497 A  (JSR Corp.),<br>12 February 2010 (12.02.2010),<br>paragraphs [0028] to [0032], [0088] to [0089]<br>& WO 2009/104465 A1      & KR 10-2010-0123678 A<br>& TW 200944582 A | 1-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013041992 A
- WO 2008105223 A
- US 20100001229 A1

- JP 2006344786 A
- JP 2015024377 A

**Non-patent literature cited in the description**

- Sulfonic acid-functionalized silica through quantitative oxidation of thiol groups. *Chem. Commun.,* 2003, 246-247

- Novel Silane Coupling Agents Containing a Photolabile 2-Nitrobenzyl Ester for Introduction of a Carboxy Group on the Surface of Silica Gel. *Chemistry Letters,* 2000, vol. 3, 228-229
- **G. W. SEARS.** *Analytical Chemistry,* 1956, vol. 28 (12), 1982-1983